# EUROPEAN PATENT APPLICATION

(11) **EP 3 869 533 A1**
(43) Date of publication of application: **25.08.2021**
(21) Application number: 20158732.6
(22) Date of filing: 21.02.2020
(51) Int. Cl.: H01J 37/12, H01J 37/153, H01J 37/28

(54) **CHARGED PARTICLE ASSESSMENT TOOL, INSPECTION METHOD**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

Charged particle assessment tools 109 and an inspection method are disclosed. A condenser lens 116 array divides a beam of charged particles 112 into a plurality of sub-beams 114. Each sub-beam is focused to a respective intermediate focus 115. Objective lenses 118 downstream from the intermediate foci project sub-beams from the condenser lens array onto a sample.

The charged particle assessment tool may comprise a plurality of field curvature correctors 126 configured to reduce field curvature.

A path 122 of each sub-beam may be substantially a straight line from each condenser lens 116 to a corresponding objective lens 118.

## Description

### FIELD

The embodiments provided herein generally relate to charged particle assessment tools and inspection methods, and particularly to charged particle assessment tools and inspection methods that use multiple sub-beams of charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface it is possible to obtain an image representing characteristics of the material structure of the surface of the sample.

There is a general need to improve the throughput and other characteristics of inspection tools and methods that use charged particle beams.

### SUMMARY

According to an aspect of the invention, there is provided a charged particle assessment tool, comprising: a condenser lens array configured to divide a beam of charged particles into a plurality of sub-beams and to focus each of the sub-beams to a respective intermediate focus; and a plurality of objective lenses downstream from the intermediate foci, each objective lens being configured to project a sub-beam from a corresponding condenser lens in the condenser lens array onto a sample, wherein: a path of each sub-beam is substantially a straight line from each condenser lens to the corresponding objective lens.

According to an aspect of the invention, there is provided a charged particle assessment tool, comprising: a condenser lens array configured to divide a beam of charged particles into a plurality of sub-beams and to focus each of the sub-beams to a respective intermediate focus; a plurality of objective lenses downstream from the intermediate foci, each objective lens being configured to project a sub-beam from a corresponding condenser lens in the condenser lens array onto a sample; and a plurality of field curvature correctors configured to reduce field curvature.

According to an aspect of the invention, there is provided a charged particle assessment tool, comprising: a condenser lens array configured to divide a beam of charged particles into a plurality of sub-beams, the condenser lens array comprising a plurality of condenser multi-electrode lenses; and a plurality of objective lenses downstream from the condenser multi-electrode lenses, each objective lens being configured to project a sub-beam from a corresponding condenser multi-electrode lens onto a sample, wherein each objective lens comprises an objective multi-electrode lens, wherein: each multi-electrode lens comprises an entry electrode through which charged particles enter the multi-electrode lens and an exit electrode through which charged particles exit the multi-electrode lens; and potentials of electrodes, and a separation between the entry electrode and exit electrode, of each condenser multi-electrode lens are set so that an off-axis chromatic aberration contributed by the condenser multi-electrode lens substantially compensates an off-axis chromatic aberration contributed by a corresponding objective multi-electrode lens.

According to an aspect of the invention, there is provided an inspection method, comprising: emitting a plurality of sub-beams of charged particles from a condenser lens array and focusing each sub-beam to a respective intermediate focus; and using a plurality of objective lenses downstream from the intermediate foci to project each sub-beam onto a sample, wherein: a path of each sub-beam is substantially a straight line from each condenser lens to a corresponding objective lens.

According to an aspect of the invention, there is provided an inspection method, comprising: emitting a plurality of sub-beams of charged particles from a condenser lens array and focusing each sub-beam to a respective intermediate focus; using a plurality of objective lenses downstream from the intermediate foci to project each sub-beam onto a sample; and using field curvature correctors to reduce field curvature.

According to an aspect of the invention, there is provided an inspection method, comprising: emitting a plurality of sub-beams of charged particles from a condenser lens array, the condenser lens array comprising a plurality of condenser multi-electrode lenses; and using a plurality of objective lenses downstream from the condenser multi-electrode lenses, each objective lens projecting a sub-beam from a corresponding condenser multi-electrode lens onto a sample, wherein each objective lens comprises an objective multi-electrode lens, wherein: each multi-electrode lens comprises an entry electrode through which charged particles enter the multi-electrode lens and an exit electrode through which charged particles exit the multi-electrode lens; and the method comprises controlling potentials of electrodes, and a separation between the entry electrode and exit electrode, of each condenser multi-electrode lens so that an off-axis chromatic aberration contributed by the condenser multi-electrode lens substantially compensates an off-axis chromatic aberration contributed by a corresponding objective multi-electrode lens.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary multi-beam apparatus that is part of the exemplary charged particle beam inspection apparatus of Figure 1.
Figure 3 is a schematic diagram of a charged particle assessment tool.
Figure 4 is a schematic diagram of a condenser multi-electrode lens.
Figure 5 is a schematic diagram of an objective multi-electrode lens.
Figure 6 is a schematic diagram of an example electron detection device.
Figure 7 is a bottom view of a detector module.
Figure 8 is a bottom view of an alternative detector module where beam apertures are in a hexagonal close packed array.
Figure 9 depicts a part of a detector module in cross section.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The following figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be considered as general references to charged particles, with the charged particles not necessarily being electrons.

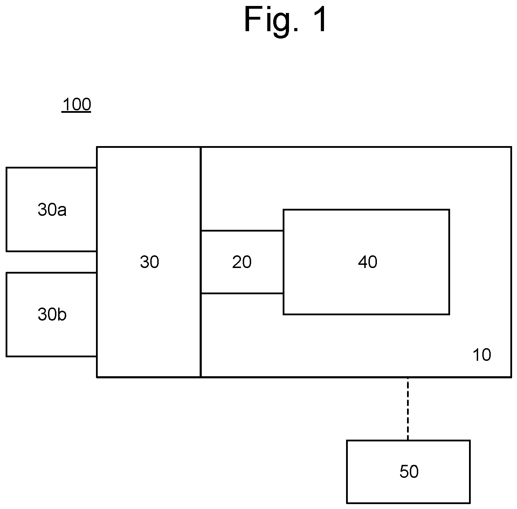

Reference is now made to Figure 1, which is a schematic diagram illustrating an exemplary charged particle beam inspection apparatus 100. The charged particle beam inspection apparatus 100 of Figure 1 includes a main chamber 10, a load lock chamber 20, a charged particle beam tool 40 (which may be referred to as an electron beam tool where electrons are used as the charged particles), an equipment front end module (EFEM) 30 and a controller 50. Charged particle beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure around the sample reaches a second pressure lower than the first pressure. After reaching the second pressure, the sample is transported to the charged particle beam tool 40 by which it may be inspected. A charged particle beam tool 40 may comprise a multi-beam electron-optical apparatus.

Controller 50 is electronically connected to charged particle beam tool 40. Controller 50 may be a processor (such as a computer) configured to control the charged particle beam inspection apparatus 100. Controller 50 may also include a processing circuitry configured to execute various signal and image processing functions. While controller 50 is shown in Figure 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus that operate under the second pressure.

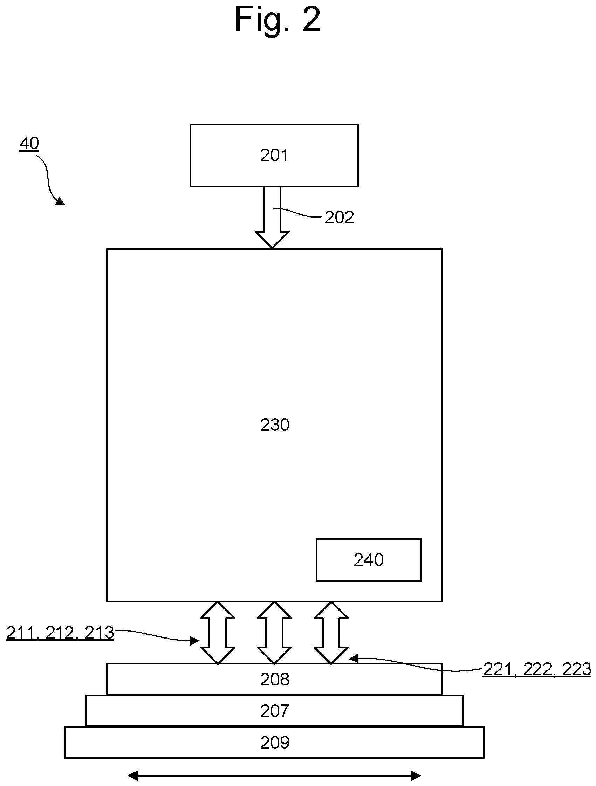

Reference is now made to Figure 2, which is a schematic diagram illustrating an exemplary charged particle beam tool 40 including a multi-beam inspection tool that is part of the exemplary charged particle beam inspection apparatus 100 of Figure 1. The charged particle beam tool 40 (also referred to herein as apparatus 40) may comprise a charged particle source 201 (e.g. an electron source), a projection apparatus 230, a motorized stage 209, and a sample holder 207. The charged particle source 201 and projection apparatus 230 may together be referred to as an electron-optical apparatus. The sample holder 207 is supported by motorized stage 209 so as to hold a sample 208 (e.g., a substrate or a mask) for inspection. The charged particle beam tool 40 may further comprise an electron detection device.

The charged particle source 201 may comprise a cathode (not shown) and an extractor or anode (not shown). The charged particle source 201 may be configured to emit electrons as primary electrons from the cathode. The primary electrons are extracted or accelerated by the extractor and/or the anode to form a charged particle beam 202 comprising primary electrons.

Projection apparatus 230 is configured to convert charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 may be connected to various parts of charged particle beam inspection apparatus 100 of Figure 1, such as charged particle source 201, electron detection device 240, projection apparatus 230, and motorized stage 209. Controller 50 may perform various image and signal processing functions. Controller 50 may also generate various control signals to govern operations of the charged particle beam inspection apparatus 100, including the charged particle beam tool 40.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons may be generated from the sample 208 which may include secondary electrons and backscattered electrons. The secondary electrons typically have electron energy ≤ 50 eV. The backscattered electrons typically have electron energy between 50 eV and the landing energy of primary sub-beams 211, 212, and 213.

Electron detection device 240 may be configured to detect secondary electrons and/or backscattered electrons and to generate corresponding signals which are sent to controller 50 or a signal processing system (not shown), e.g. to construct images of the corresponding scanned areas of sample 208. The electron detection device 240 may be incorporated into the projection apparatus 230 or may be separate therefrom, with a secondary optical column being provided to direct secondary electrons and/or backscattered electrons to the electron detection device 240.

The controller 50 may comprise an image processing system that includes an image acquirer (not shown) and a storage device (not shown). For example, the controller 50 may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the charged particle beam tool 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of detected charged particles (e.g. secondary electrons). The charged particle (e.g. electron) distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

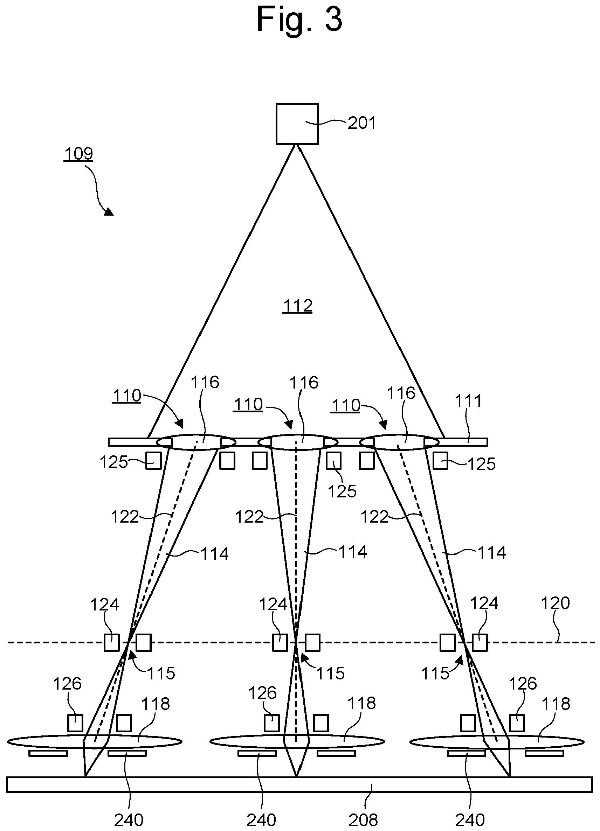

Figure 3 is a schematic diagram of a charged particle assessment tool 109 of an embodiment. The charged particle assessment tool 109 may form part of a charged particle beam tool 40 according to any of the variations described above with reference to Figure 2. The charged particle assessment tool 109 may be used as part of a charged particle beam inspection apparatus 100 as described above.

The charged particle assessment tool 109 comprises a condenser lens array. The condenser lens array divides a beam 112 of charged particles into a plurality of sub-beams 114. In an embodiment, the condenser lens array focuses each of the sub-beams 114 to a respective intermediate focus 115.

In the embodiment shown, the condenser lens array comprises a plurality of beam apertures 110. The beam apertures 110 may be formed, for example, by openings in a substantially planar beam aperture body 111. The beam apertures 110 divide a beam 112 of charged particles into a corresponding plurality of sub-beams 114. In some embodiments, the charged particles comprise or consist of electrons. The charged particles are provided by a charged particle source 201. The charged particle source 201 may or may not form part of the charged particle assessment tool 109. The charged particle source 201 may be configured in any of the ways described above with reference to Figure 2. The charged particle source 201 may thus comprise a cathode (not shown) and an extractor or anode (not shown). The charged particle source 201 may comprise a high brightness thermal field emitter with a desirable balance between brightness and total emission current.

In the embodiment shown, the condenser lens array comprises a plurality of condenser lenses 116. The plurality of condenser lenses 116 may be considered an array of condenser lenses and may be in a common plane. Each condenser lens 116 may be associated with a corresponding one of the beam apertures 110. Each condenser lens 116 may, for example, be formed within a beam aperture 110, be positioned directly adjacent to a beam aperture 110, and/or be integrated with the beam aperture body 111 (e.g. with the beam aperture body 111 forming one of the electrodes of the condenser lens 116). Thus, a plate or array that forms an electrode of the condenser lens array may also serve as a beam aperture.

The condenser lenses 116 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The lens array may take the form of at least two plates, acting as electrodes, with an aperture in each plate aligned with each other and corresponding to the location of a sub-beam. At least two of the plates are maintained during operation at different potentials to achieve the desired lensing effect. In an arrangement the condenser lens array is formed of three plate arrays in which charged particles have the same energy as they enter and leave each lens, which arrangement may be referred to as an Einzel lens. Einzel lenses (e.g. including those that may be used in the condenser lens array) may also typically have electrodes (e.g. plate arrays) arranged symmetrically relative to each other, such as with entry and exit electrodes equidistant from an electrode between them. The entry and exit electrodes are also typically held at the same potential. In other arrangements the condenser lens is formed of four or more electrodes (e.g. plate arrays) in which charged particles have the same energy as they enter and leave each lens. Such arrangements may again have entry and exit electrodes held at the same potential and/or symmetric arrangements of the electrodes, but because there are more than three electrodes these arrangements may not strictly be considered Einzel lenses. Arranging the lenses (whether or not the lenses are strictly Einzel lenses) so that the charged particles have the same energy as they enter and leave each lens means that dispersion only occurs within each lens (between entry and exit electrodes of the lens), thereby limiting off-axis chromatic aberrations. When the thickness of the condenser lenses is low, e.g. a few mm, such aberrations have a small or negligible effect.

Each condenser lens 116 focuses one (e.g. a different respective one) of the sub-beams 114 to a respective intermediate focus 115. The intermediate foci 115 of the plurality of condenser lenses 116 may substantially lie in a common plane, which may be referred to as an intermediate image plane 120.

The charged particle assessment tool 109 further comprises a plurality of objective lenses 118. The objective lenses 118 are downstream from the intermediate foci (and intermediate image plane 120). The plurality of objective lenses 118 may be considered an array of objective lenses and may be in a common plane. Each objective lens 118 projects one of the sub-beams 114 (from a corresponding condenser lens 116) onto a sample 208 to be assessed. Thus, there may be a one-to-one correspondence between the condenser lenses 116 and the objective lenses 118, with each sub-beam 114 propagating between a pair of condenser lens 116 and objective lens 118 that is unique to that sub-beam. A corresponding one-to-one correspondence may exist between the beam apertures 110 of the condenser lens array and the objective lenses 118.

The charged particle assessment tool 109 is configured so that a path 122 of each sub-beam 114 (e.g. of a principle ray of the sub-beam 114, corresponding to a beam axis of the sub-beam 114) is substantially a straight line from each condenser lens 116 to a corresponding objective lens 118 (i.e. to the objective lens 118 that corresponds to that condenser lens 116). The straight path may further extend to the sample 208. No collimators are therefore present between the condenser lenses 116 and the objective lenses 118. As described below, the absence of collimators may decrease system complexity and/or allow additional aberration correction modes (e.g. mutual compensation of off-axis chromatic aberrations by the condenser lenses 116 and objective lenses 118). The approach may additionally allow the beam current to be increased by allowing the objective lenses to be provided at a larger pitch. This is because the larger pitch allows lens apertures of the objective lenses 118 to be increased in size, which results in lower aberrations. Lower aberrations allow the beam current to be increased.

In some embodiments, as exemplified in Figure 3, the charged particle assessment tool 109 further comprises one or more aberration correctors 124, 125, 126 that reduce one or more aberrations in the sub-beams 114. In an embodiment, each of at least a subset of the aberration correctors 124 is positioned in, or directly adjacent to, a respective one of the intermediate foci 115 (e.g. in or adjacent to the intermediate image plane 120). The sub-beams 114 have a smallest cross-sectional area in or near a focal plane such as the intermediate plane 120. This provides more space for aberration correctors 124 than is available elsewhere, i.e. upbeam or downbeam of the intermediate plane 120 (or than would be available in alternative arrangements that do not have an intermediate image plane 120). In an embodiment, aberration correctors 124 positioned in, or directly adjacent to, the intermediate foci 115 (or intermediate image plane 120) comprise deflectors to correct for the source 201 appearing to be at different positions for different beams. Correctors 124 can be used to correct macroscopic aberrations resulting from the source 201 that prevent a good alignment between each sub-beam 114 and a corresponding objective lens 118. The aberration correctors 124 may correct aberrations that prevent a proper column alignment. Such aberrations may also lead to a misalignment between the sub-beams 114 and the correctors 124. For this reason, it may be desirable to additionally or alternatively position aberration correctors 125 at or near the condenser lenses 116 (e.g. with each such aberration corrector 125 being integrated with, or directly adjacent to, one or more of the condenser lenses 116). This is desirable because at or near the condenser lenses 116 aberrations will not yet have led to a shift of corresponding sub-beams 114 because the condenser lenses 116 are vertically close or coincident with the beam apertures 110. A challenge with positioning correctors 125 at or near the condenser lenses 116, however, is that the sub-beams 114 each have relatively large cross-sectional areas and relatively small pitch at this location, relative to locations further downstream.

In some embodiments, as exemplified in Figure 3, each of at least a subset of the aberration correctors 126 is integrated with, or directly adjacent to, one or more of the objective lenses 118. In an embodiment, these aberration correctors 126 reduce one or more of the following: field curvature; focus error; and astigmatism. Additionally or alternatively, one or more scanning deflectors (not shown) may be integrated with, or directly adjacent to, one or more of the objective lenses 118 for scanning the sub-beams 114 over the sample 208. Such an arrangement may be implemented for example as described in EP2425444A1 hereby incorporated by reference in particular to the disclosure of the use of an aperture array as a scanning deflector.

The aberration correctors 124, 125may be CMOS based individual programmable deflectors as disclosed in EP2702595A1 or an array of multipole deflectors as disclosed EP2715768A2, of which the descriptions of the beamlet manipulators in both documents are hereby incorporated by reference.

In an embodiment, aberration correctors, for example the aberration correctors 126 associated with the objective lenses 118, comprise field curvature correctors that reduce field curvature. Reducing field curvature reduces errors caused by field curvature, such as astigmatism and focus error. In the absence of correction, significant field curvature aberration effects are expected to occur at the objective lenses 118 in embodiments where the sub-beams 114 propagate along straight-line paths between the condenser lenses 116 and the objective lenses 118 due to the resulting oblique angles of incidence onto the objective lenses 118. Field curvature effects could be reduced or removed by collimating the sub-beams 114 before the sub-beams 114 reach the objective lenses 118. However, the provision of collimators upstream of the objective lenses 118 would add complexity. The field curvature correctors make it possible to avoid collimators and thereby reduce complexity. As mentioned above, the absence of collimators upstream of the objective lenses 118 may additionally allow the beam current to be increased by allowing the objective lenses to be provided at a larger pitch.

In an embodiment, the field curvature correctors are integrated with, or directly adjacent to, one or more of the objective lenses 118. In an embodiment, the field curvature correctors comprise passive correctors. Passive correctors could be implemented, for example, by varying the diameter and/or ellipticity of apertures of the objective lenses 118. The passive correctors may be implemented for example as described in EP2575143A1 hereby incorporated by reference in particular to the disclosed use of aperture patterns to correct astigmatism. The passive nature of passive correctors is desirable because it means that no controlling voltages are required. In embodiments where the passive correctors are implemented by varying the diameter and/or ellipticity of apertures of the objective lenses 118, the passive correctors provide the further desirable feature of not requiring any additional elements, such as additional lens elements. A challenge with passive correctors is that they are fixed, so the required correction needs to be carefully calculated in advance. Additionally or alternatively, in an embodiment, the field curvature correctors comprise active correctors. The active correctors may controllably correct charged particles to provide the correction. The correction applied by each active corrector may be controlled by controlling the potential of each of one or more electrodes of the active corrector. In an embodiment, passive correctors apply a coarse correction and active correctors apply a finer and/or tunable correction.

In some embodiments, aberrations contributed by the objective lenses 118 are at least partially compensated by aberrations contributed by the condenser lenses 116. This arrangement is particularly effective where no collimation is performed between the objective lenses 118 and the condenser lenses 116 (e.g. where a path of each sub-beam 114 is substantially a straight line from each condenser lens 116 to the corresponding objective lens 118).

In one class of embodiment, off-axis chromatic aberrations contributed by the objective lenses 118 are at least partially compensated by off-axis chromatic aberrations contributed by the condenser lenses 116. In an embodiment, this is implemented by arranging for off-axis chromatic aberrations contributed by the objective lenses 118 to be opposite in sign to off-axis chromatic aberrations contributed by the condenser lenses 116. The compensation can be made complete (or more complete) by deliberately adjusting the amount of off-axis chromatic aberrations contributed by the objective lenses 118 or condenser lenses 116. For example, the amount of off-axis chromatic aberrations contributed by the condenser lenses 116 may be deliberately increased (e.g. by increasing a distance between electrodes of the condenser lenses) to increase an extent to which off-axis chromatic aberrations contributed by the objective lenses 118 (which are typically higher) are compensated.

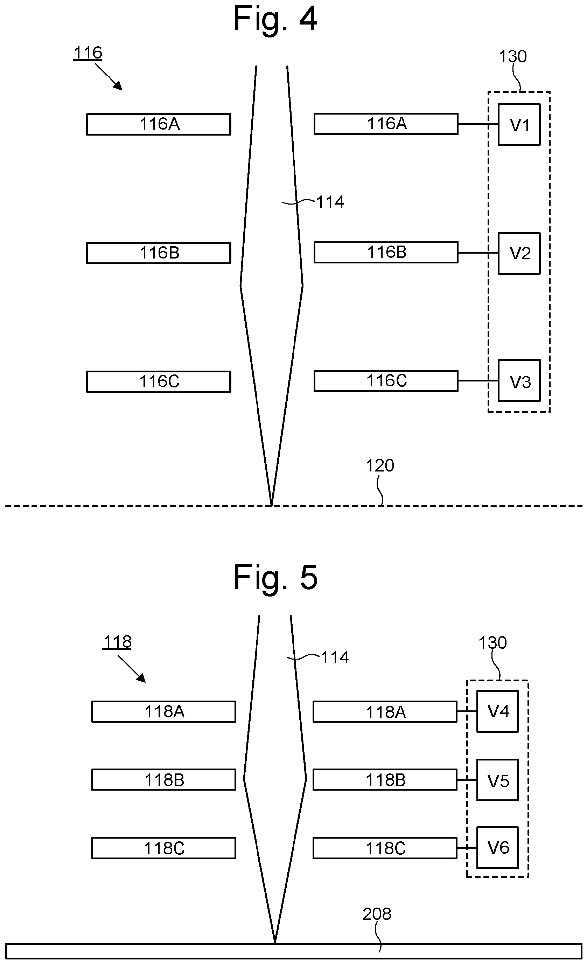

In some embodiments of this type, as exemplified in Figure 4, each condenser lens 116 comprises a multi-electrode lens, which may be referred to as a condenser multi-electrode lens. In the example shown, the multi-electrode lens comprises three-electrodes and may be configured to operate as an Einzel lens. The dimensions shown in Figure 4 are schematic to aid visualization. In practice, the distances between the electrodes relative to the diameter of the lens aperture will typically be larger than shown (optionally 10-1000 times larger). The multi-electrode lens has an entry electrode 116A and an exit electrode 116C. Charged particles enter the multi-electrode lens through the entry electrode 116A and exit the multi-electrode lens through the exit electrode 116C. At least one further electrode 116B is provided between the entry electrode 116A and the exit electrode 116C. The tool 109 is configured, e.g. via an electric power source 130, to control electric potentials of electrodes 116A-116C of each condenser multi-electrode lens. In the example shown, tool 109 holds the entry electrode 116A at a potential V1, holds the further electrode 116B at a potential V2, and holds the exit electrode 116C at a potential V3. In some embodiments, the tool 109 controls electric potentials of the electrodes 116A-116C of each condenser multi-electrode lens such that there is substantially no difference in energy between particles entering and exiting the condenser multi-electrode lens. The sub-beam entrance energy is substantially the same as its exit energy. Any loss of energy of a charged particle within the multi-electrode lens is regained by the time the charged particle leaves the multi-electron lens. In the example shown, this could be achieved by arranging for V1 and V3 to be equal to each other and for V2 to be different, thereby varying an energy of the charged particles (e.g. by accelerating and decelerating the charged particles) while they are between the entry electrode 116A and exit electrode 116C to achieve a desired lensing effect. Where the multi-electrode lens comprises three electrodes, such a lens may be referred to as an Einzel lens as described above.

In an embodiment, as exemplified in Figure 5, each objective lens 118 also comprises a multi-electrode lens, which may be referred to as an objective multi-electrode lens. The dimensions shown in Figure 5 are schematic to aid visualization. In practice, the distances between the electrodes relative to the diameter of the lens aperture will typically be larger than shown (optionally such that the distances between the electrodes are roughly equal to the hole diameter). The multi-electrode lens has an entry electrode 118A and an exit electrode 118C. Charged particles enter the multi-electrode lens through the entry electrode 118A and exit the multi-electrode lens through the exit electrode 118C. At least one further electrode 118B is provided between the entry electrode 118A and the exit electrode 118C. The tool 109 is configured, e.g. via an electric power source 130, to control electric potentials of electrodes 118A-118C of each objective multi-electrode lens. In the example shown, tool 109 holds the entry electrode 118A at a potential V4, holds the further electrode 118B at a potential V5, and holds the exit electrode 118C at a potential V6. In some embodiments, the tool 109 controls electric potentials of electrodes 118A-C of each objective multi-electrode lens such that there is substantially no difference in energy between particles entering and exiting the objective multi-electrode lens. In the example shown, this could be achieved by arranging for V4 and V6 to be equal to each other and for V5 to be different, thereby varying an energy of the charged particles (e.g. by accelerating and decelerating the charged particles) while they are between the entry electrode 118A and exit electrode 118C to achieve a desired lensing effect. Thus, when the objective multi-electrode lenses each comprise three electrodes, the objective multi-electrode lenses may be referred to as Einzel lenses.

In typical (non-Einzel) lenses, the size of a contribution to off-axis chromatic aberration of a sub-beam from the lens depends on a distance from the lens to an image plane. This is not the case for multi-electrodes lenses (such as Einzel lenses) where there is no overall change in energy of charged particles passing through the lenses. Instead, the size of a contribution to off-axis chromatic aberration of a sub-beam from the multi-electrode lens depends predominantly on the internal dimensions of the multi-electrode lens itself (because the energies of charged particles do change within the multi-electrode lens). If the multi-electrode lens is very thin, the contribution to off-axis chromatic aberration will be small or negligible. Conversely, if the multi-electrode lens is made thicker a contribution to off-axis chromatic aberration can become significant.

The multi-electrode lenses in embodiments of the present disclosure may need to be compatible with certain functionality. For example, in the case of the condenser multi-electrode lenses, the multi-electrode lenses may be required to provide a desired demagnification and/or opening angle for the objective lenses 118. Even with these functional constraints, there is still sufficient freedom in configuring the multi-electrode lenses (including freedom to vary the dimensions of the multi-electrode lens) that it is possible to control a size of the contribution to off-axis chromatic aberration from the multi-electrode lens. For example, if the potentials applied to the electrodes are suitably adapted, it is possible to increase a separation between the entry electrode 116A and the exit electrode 116C of the multi-electrode lenses to increase a contribution to off-axis chromatic aberration from the multi-electrode lenses while still providing the desired demagnification and opening angle for the objective lenses 118.

In an embodiment, based on the above insight, potentials V1-V3 of the electrodes, and a separation between the entry electrode 116A and exit electrode 116C, of each condenser multi-electrode lens are set so that an off-axis chromatic aberration contributed by the condenser multi-electrode lens substantially compensates an off-axis chromatic aberration contributed by a corresponding objective multi-electrode lens. As exemplified in Figures 4 and 5, this approach may cause a separation between the entry electrode 116A and the exit electrode 116C of each condenser multi-electrode lens to be larger than a separation between the entry electrode 118A and the exit electrode 118C of the corresponding objective multi-electrode lens. In an example implementation, the separation between the entry electrode 116A and the exit electrode 116C of a condenser multi-electrode lens is roughly 3mm, compared with a separation between the entry electrode 118A and the exit electrode 118C of an objective multi-electrode lenses of the order of 0.15mm. A significantly larger separation for the condenser multi-electrode lens is likely be needed because the off-axis chromatic aberration contributed by the condenser multi-electrode lens is demagnified by the objective lens 118, which means the off-axis chromatic aberration contributed by the condenser multi-electrode lens must be much larger than the off-axis chromatic aberration contributed by the objective multi-electrode lens in order to compensate it. The required increase in separation between the entry electrode 116A and the exit electrode 116C of the condenser multi-electrode lens can be implemented while still achieving the required demagnification and opening angle for the objective lenses 118.

In an embodiment, the energy profile of charged particles passing through the condenser multi-electrode lenses is arranged to be opposite to the energy profile of charged particles passing through the objective multi-electrode lenses. This may be achieved, for example, by arranging for the charged particles to be first accelerated and then decelerated in the condenser lenses 116 and to be first decelerated and then accelerated in the objective lenses 118. In an embodiment of this type, the potentials of the electrodes 116A-116C of each condenser multi-electrode lens are set such that energies of charged particles are increased between the entry electrode 116A of the condenser multi-electrode lens and the further electrode 116B closest to the entry electrode 116A of the condenser multi-electrode lens. The potentials of the electrodes 118A-118C of each objective multi-electrode lens are then set such that energies of charged particles are decreased between the entry electrode 118A of the objective multi-electrode lens and the further electrode 118B closest to the entry electrode 118A of the objective multi-electrode lens. Arrangements of this type are beneficial because the lowering of the energies of charged particles between the first two electrodes 118A-118B of the objective multi-electrode lenses keeps overall electric fields lower in the objective lenses 118.

Alternatively, the charged particles could be first decelerated and then accelerated in the condenser lenses 116 and be first accelerated and then decelerated in the objective lenses 118. In an embodiment of this type, the potentials of the electrodes 116A-116C of each condenser multi-electrode lens are set such that energies of charged particles are decreased between the entry electrode 116A of the condenser multi-electrode lens and the further electrode 116B closest to the entry electrode 116A of the condenser multi-electrode lens. The potentials of the electrodes of each objective multi-electrode lens are then set such that energies of charged particles are increased between the entry electrode 118A of the objective multi-electrode lens and the further electrode 118B closest to the entry electrode 118A of the objective multi-electrode lens.

The above-described mutual compensation of off-axis chromatic aberrations by the condenser lenses 116 and objective lenses 118 would not be possible in the manner described if the sub-beams 114 were collimated before reaching the objective lenses 118. The approach is thus made possible by the arranging of the charged particle assessment tool 109 to ensure that the path of each sub-beam 114 is substantially a straight line from each condenser lens 116 to the corresponding objective lens 118. In embodiments incorporating the mutual compensation of off-axis chromatic aberrations, it is desirable to focus the sub-beams 114 to intermediate foci as depicted in Figure 3 for the reasons mentioned above. However, it is also possible to arrange for the condenser lens array to project the sub-beams 114 onto the objective lenses 118 without forming any intermediate foci in between.

In an embodiment, the charged particle assessment tool 109 comprises an electron detection device 240 that detects either or both of secondary electrons and backscattered electrons from the sample. In the example shown in Figure 3, the electron detection device 240 is integrated with the objective lenses 118. The electron detection device 240 may, for example, comprise a CMOS chip detector integrated with a bottom electrode of one or more of the objective lenses 118. Alternatively, a secondary optical column may be provided to direct secondary electrons and/or backscattered electrons to an electron detection device 240 positioned elsewhere. As described above, the electron detection device 240 may generate signals that are sent to a controller 50 or a signal processing system as described above with reference to Figures 1 and 2, e.g. to construct images of areas of the sample 208 scanned over by the charged particle assessment tool 109 or perform other post-processing.

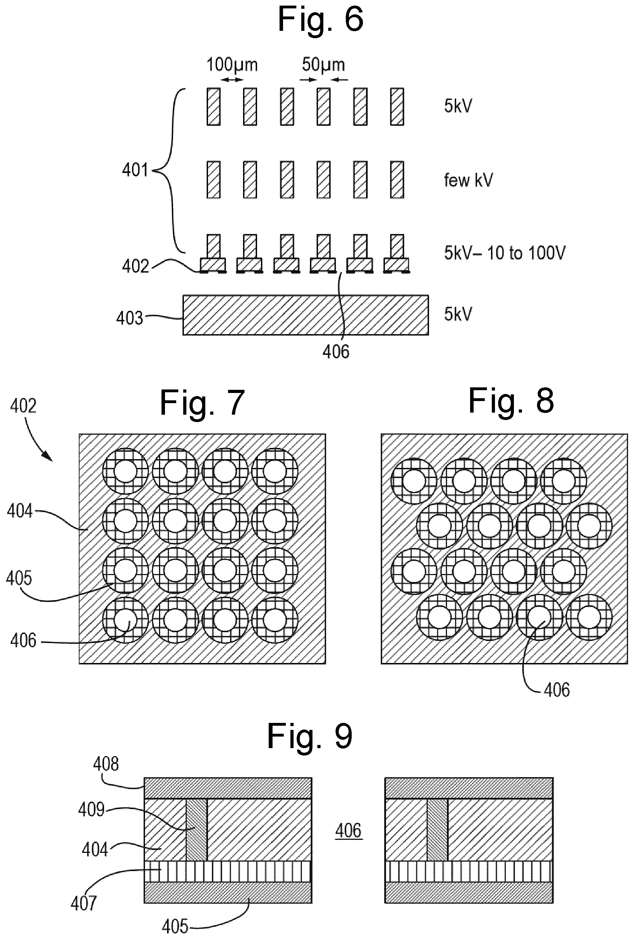

In an embodiment, as exemplified in Figures 6-9 discussed below, the objective lenses 118 comprise multi-electrode lenses in which a bottom electrode of the multi-electrode lenses is integrated with a CMOS chip detector array. Integration of a detector array into the objective lenses 118 replaces the need for a secondary column for detecting the secondary electrons and backscattered electrons. The CMOS chip is preferably orientated to face a sample (because of the small distance (e.g. 100µm) between wafer and bottom of the electron-optical system). In an embodiment, electrodes to capture the secondary electron signals are formed in the top metal layer of the CMOS device. The electrodes can be formed in other layers. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In order to maximize the detection efficiency it is desirable to make the electrode surface as large as possible, so that substantially all the area of the array objective lens (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single electrode surrounds each aperture. In another embodiment, a plurality of electrode elements are provided around each aperture. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by electrode is amplified by a Trans Impedance Amplifier.

An exemplary embodiment is shown in Figure 6 which illustrates a multibeam objective lens 401 in schematic cross section. On the output side of the objective lens 401, the side facing the sample 403, a detector module 402 is provided. Figure 7 is a bottom view of detector module 402 which comprises a substrate 404 on which are provided a plurality of capture electrodes 405 each surrounding a beam aperture 406. The beam apertures 406 may be formed by etching through substrate 404. In the arrangement shown in Figure 7, the beam apertures 406 are shown in a rectangular array. The beam apertures 406 can also be differently arranged, e.g. in a hexagonal close packed array as depicted in Figure 8.

Figure 9 depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallisation layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

Embodiments of the disclosure may be provided in the form of methods, which may use any of the arrangements described above, or other arrangements. In an embodiment, an inspection method is provided. The method comprises emitting a plurality of sub-beams 114 of charged particles from a condenser lens array and focusing each sub-beam 114 to a respective intermediate focus 115. A plurality of objective lenses 118 downstream from the intermediate foci 115 are used to project each sub-beam 114 onto a sample 208. A path 122 of each sub-beam 114 is substantially a straight line from each condenser lens 116 to a corresponding objective lens 118. Alternatively or additionally, the method comprises using field curvature correctors to reduce field curvature. In a further embodiment, an inspection method is provided in which a plurality of sub-beams of charged particles are emitted from a condenser lens array. The condenser lens array comprising a plurality of condenser multi-electrode lenses. A plurality of objective lenses 118 downstream from the condenser multi-electrode lenses, each objective lens projecting a sub-beam 114 from a corresponding condenser multi-electrode lens onto a sample 208. Each objective lens 118 comprises an objective multi-electrode lens. Each multi-electrode lens comprises an entry electrode 116A, 118A through which charged particles enter the multi-electrode lens and an exit electrode 116C, 118C through which charged particles exit the multi-electrode lens. The method comprises controlling potentials of electrodes, and a separation between the entry electrode 116A and exit electrode 116C, of each condenser multi-electrode lens so that an off-axis chromatic aberration contributed by the condenser multi-electrode lens substantially compensates an off-axis chromatic aberration contributed by a corresponding objective multi-electrode lens.

An assessment tool according to an embodiment of the invention may be a tool which makes a qualitative assessment of a sample (e.g. pass/fail), one which makes a quantitative measurement (e.g. the size of a feature) of a sample or which generates an image of map of a sample. Examples of assessment tools are inspection tools (e.g. for identifying defects), review tools (e.g. for classifying defects) and metrology tools.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

The invention may be provided as in the following clauses:
Clause 1: A charged particle assessment tool, comprising:
   a condenser lens array configured to divide a beam of charged particles into a plurality of sub-beams and to focus each of the sub-beams to a respective intermediate focus; and
   a plurality of objective lenses downstream from the intermediate foci, each objective lens being configured to project a sub-beam from a corresponding condenser lens in the condenser lens array onto a sample, wherein:
   a path of each sub-beam is substantially a straight line from each condenser lens to the corresponding objective lens.
Clause 2: The tool of clause 1, further comprising one or more aberration correctors configured to reduce one or more aberrations in the sub-beams.
Clause 3: The tool of clause 2, wherein each of at least a subset of the aberration correctors is positioned in, or directly adjacent to, a respective one of the intermediate foci.
Clause 4: The tool of clause 2 or 3, wherein each of at least a subset of the aberration correctors is integrated with, or directly adjacent to, one or more of the objective lenses or one or more of the condenser lenses.
Clause 5: The tool of any of clauses 2-4, wherein the aberration correctors comprise field curvature correctors configured to reduce field curvature.
Clause 6: A charged particle assessment tool, comprising:
   a condenser lens array configured to divide a beam of charged particles into a plurality of sub-beams and to focus each of the sub-beams to a respective intermediate focus;
   a plurality of objective lenses downstream from the intermediate foci, each objective lens being configured to project a sub-beam from a corresponding condenser lens in the condenser lens array onto a sample; and
   a plurality of field curvature correctors configured to reduce field curvature.
Clause 7: The tool of clause 6, wherein each of at least a subset of the field curvature correctors is integrated with, or directly adjacent to, one or more of the objective lenses.
Clause 8: The tool of any preceding clause, wherein aberrations contributed by the objective lenses are at least partially compensated by aberrations contributed by the condenser lens array.
Clause 9: The tool of any preceding clause, wherein off-axis chromatic aberrations contributed by the objective lenses are at least partially compensated by off-axis chromatic aberrations contributed by the condenser lens array.
Clause 10: The tool of any preceding clause, wherein the condenser lens array comprises a plurality of beam apertures for the dividing of the beam of charged particles into a corresponding plurality of sub-beams.
Clause 11: The tool of any preceding clause, wherein the condenser lens array comprises a plurality of condenser lenses, each condenser lens being configured to focus a different one of the sub-beams to the respective intermediate focus.
Clause 12: The tool of clause 11, wherein:
   each condenser lens comprises a condenser multi-electrode lens, the multi-electrode lens comprising an entry electrode through which charged particles enter the multi-electrode lens, an exit electrode through which charged particles exit the multi-electrode lens, and at least one further electrode between the entry electrode and the exit electrode; and
   the tool is configured to control electric potentials of electrodes of each condenser multi-electrode lens such that there is substantially no difference in energy between particles entering and exiting the condenser multi-electrode lens.
Clause 13: The tool of clause 12, wherein:
   each objective lens comprises an objective multi-electrode lens, the multi-electrode lens comprising an entry electrode through which charged particles enter the multi-electrode lens, an exit electrode through which charged particles exit the multi-electrode lens, and at least one further electrode between the entry electrode and the exit electrode; and
   the tool is configured to control electric potentials of electrodes of each objective multi-electrode lens such that there is substantially no difference in energy between particles entering and exiting the objective multi-electrode lens.
Clause 14: The tool of clause 13, wherein the potentials of the electrodes, and a separation between the entry electrode and exit electrode, of each condenser multi-electrode lens are set so that an off-axis chromatic aberration contributed by the condenser multi-electrode lens substantially compensates an off-axis chromatic aberration contributed by a corresponding objective multi-electrode lens.
Clause 15: The tool of clause 14, wherein:
   the potentials of the electrodes of each condenser multi-electrode lens are set such that energies of charged particles are increased between the entry electrode of the condenser multi-electrode lens and the further electrode closest to the entry electrode of the condenser multi-electrode lens; and
   the potentials of the electrodes of each objective multi-electrode lens are set such that energies of charged particles are decreased between the entry electrode of the objective multi-electrode lens and the further electrode closest to the entry electrode of the objective multi-electrode lens.
Clause 16: The tool of clause 14, wherein:
   the potentials of the electrodes of each condenser multi-electrode lens are set such that energies of charged particles are decreased between the entry electrode of the condenser multi-electrode lens and the further electrode closest to the entry electrode of the condenser multi-electrode lens; and
   the potentials of the electrodes of each objective multi-electrode lens are set such that energies of charged particles are increased between the entry electrode of the objective multi-electrode lens and the further electrode closest to the entry electrode of the objective multi-electrode lens.
Clause 17: The tool of any of clauses 13-16, wherein a separation between the entry electrode and the exit electrode of each condenser multi-electrode lens is larger than a separation between the entry electrode and the exit electrode of the corresponding objective multi-electrode lens.
Clause 18: The tool of any preceding clause, further comprising an electron detection device configured to detect either or both of secondary electrons and backscattered electrons from the sample.
Clause 19: A charged particle assessment tool, comprising:
   a condenser lens array configured to divide a beam of charged particles into a plurality of sub-beams, the condenser lens array comprising a plurality of condenser multi-electrode lenses; and
   a plurality of objective lenses downstream from the condenser multi-electrode lenses, each objective lens being configured to project a sub-beam from a corresponding condenser multi-electrode lens onto a sample, wherein each objective lens comprises an objective multi-electrode lens, wherein:
      each multi-electrode lens comprises an entry electrode through which charged particles enter the multi-electrode lens and an exit electrode through which charged particles exit the multi-electrode lens; and
      potentials of electrodes, and a separation between the entry electrode and exit electrode, of each condenser multi-electrode lens are set so that an off-axis chromatic aberration contributed by the condenser multi-electrode lens substantially compensates an off-axis chromatic aberration contributed by a corresponding objective multi-electrode lens.
Clause 20: The tool of clause 19, wherein each multi-electrode lens comprises at least one further lens in between the entry electrode and the exit electrode of the multi-electrode lens.
Clause 21: An inspection method, comprising:
   emitting a plurality of sub-beams of charged particles from a condenser lens array and focusing each sub-beam to a respective intermediate focus; and
   using a plurality of objective lenses downstream from the intermediate foci to project each sub-beam onto a sample, wherein:
   a path of each sub-beam is substantially a straight line from each condenser lens to a corresponding objective lens.
Clause 22: An inspection method, comprising:
   emitting a plurality of sub-beams of charged particles from a condenser lens array and focusing each sub-beam to a respective intermediate focus;
   using a plurality of objective lenses downstream from the intermediate foci to project each sub-beam onto a sample; and
   using field curvature correctors to reduce field curvature.
Clause 23: The method of clause 21 or 22, wherein aberrations contributed by the objective lenses are at least partially compensated by aberrations contributed by the condenser lens array.
Clause 24: The method of any of clauses 21-23, wherein off-axis chromatic aberrations contributed by the objective lenses are at least partially compensated by off-axis chromatic aberrations contributed by the condenser lens array.
Clause 25: The method of any of clauses 21-24, further comprising detecting either or both of secondary electrons and backscattered electrons from the sample.
Clause 26: An inspection method, comprising:
   emitting a plurality of sub-beams of charged particles from a condenser lens array, the condenser lens array comprising a plurality of condenser multi-electrode lenses; and
   using a plurality of objective lenses downstream from the condenser multi-electrode lenses, each objective lens projecting a sub-beam from a corresponding condenser multi-electrode lens onto a sample, wherein each objective lens comprises an objective multi-electrode lens, wherein:
      each multi-electrode lens comprises an entry electrode through which charged particles enter the multi-electrode lens and an exit electrode through which charged particles exit the multi-electrode lens; and
      the method comprises controlling potentials of electrodes, and a separation between the entry electrode and exit electrode, of each condenser multi-electrode lens so that an off-axis chromatic aberration contributed by the condenser multi-electrode lens substantially compensates an off-axis chromatic aberration contributed by a corresponding objective multi-electrode lens.

## Claims

1. A charged particle assessment tool, comprising:
a condenser lens array configured to divide a beam of charged particles into a plurality of sub-beams and to focus each of the sub-beams to a respective intermediate focus;
a plurality of objective lenses downstream from the intermediate foci, each objective lens being configured to project a sub-beam from a corresponding condenser lens in the condenser lens array onto a sample; and
a plurality of field curvature correctors configured to reduce field curvature.

2. The tool of claim 1, wherein each of at least a subset of the field curvature correctors is integrated with, or directly adjacent to, one or more of the objective lenses.

3. A charged particle assessment tool, comprising:
a condenser lens array configured to divide a beam of charged particles into a plurality of sub-beams and to focus each of the sub-beams to a respective intermediate focus; and
a plurality of objective lenses downstream from the intermediate foci, each objective lens being configured to project a sub-beam from a corresponding condenser lens in the condenser lens array onto a sample, wherein:
a path of each sub-beam is substantially a straight line from each condenser lens to the corresponding objective lens.

4. The tool of claim 3, further comprising one or more aberration correctors configured to reduce one or more aberrations in the sub-beams.

5. The tool of claims 4, wherein the aberration correctors comprise field curvature correctors configured to reduce field curvature.

6. The tool of any preceding claim, wherein aberrations contributed by the objective lenses are at least partially compensated by aberrations contributed by the condenser lens array.

7. The tool of any preceding claim, wherein off-axis chromatic aberrations contributed by the objective lenses are at least partially compensated by off-axis chromatic aberrations contributed by the condenser lens array.

8. The tool of any preceding claim, wherein the condenser lens array comprises a plurality of beam apertures for the dividing of the beam of charged particles into a corresponding plurality of sub-beams.

9. The tool of any preceding claim, wherein the condenser lens array comprises a plurality of condenser lenses, each condenser lens being configured to focus a different one of the sub-beams to the respective intermediate focus.

10. The tool of claim 9, wherein:
each condenser lens comprises a condenser multi-electrode lens, the multi-electrode lens comprising an entry electrode through which charged particles enter the multi-electrode lens, an exit electrode through which charged particles exit the multi-electrode lens, and at least one further electrode between the entry electrode and the exit electrode; and
the tool is configured to control electric potentials of electrodes of each condenser multi-electrode lens such that there is substantially no difference in energy between particles entering and exiting the condenser multi-electrode lens.

11. The tool of claim 10, wherein:
each objective lens comprises an objective multi-electrode lens, the multi-electrode lens comprising an entry electrode through which charged particles enter the multi-electrode lens, an exit electrode through which charged particles exit the multi-electrode lens, and at least one further electrode between the entry electrode and the exit electrode; and
the tool is configured to control electric potentials of electrodes of each objective multi-electrode lens such that there is substantially no difference in energy between particles entering and exiting the objective multi-electrode lens.

12. The tool of claim 11, wherein the potentials of the electrodes, and a separation between the entry electrode and exit electrode, of each condenser multi-electrode lens are set so that an off-axis chromatic aberration contributed by the condenser multi-electrode lens substantially compensates an off-axis chromatic aberration contributed by a corresponding objective multi-electrode lens.

13. The tool of any of claims 11 or 12, wherein a separation between the entry electrode and the exit electrode of each condenser multi-electrode lens is larger than a separation between the entry electrode and the exit electrode of the corresponding objective multi-electrode lens.

14. The tool of any preceding claim, further comprising an electron detection device configured to detect either or both of secondary electrons and backscattered electrons from the sample.

15. An inspection method, comprising:
emitting a plurality of sub-beams of charged particles from a condenser lens array and focusing each sub-beam to a respective intermediate focus;
using a plurality of objective lenses downstream from the intermediate foci to project each sub-beam onto a sample; and
using field curvature correctors to reduce field curvature.
